# EUROPEAN PATENT SPECIFICATION

(11) **EP 2 214 464 B1**
(45) Date of publication and mention of the grant of the patent: **01.04.2015**
(21) Application number: 09290078.6
(22) Date of filing: 02.02.2009
(51) Int. Cl.: H05K 7/18

(54) **Modular rack design with common mounting flanges and improved cabling space**
Modulare Gestellanordnung mit gemeinsamen Befestigungsflanschen und verbessertem Verkabelungsraum
Conception d'étagères modulaires dotée de brides de montage courantes et espace de câblage amélioré

(43) Date of publication of application: 04.08.2010
(73) Proprietor: ALCATEL LUCENT, 92100 Boulogne-Billancourt (FR)
(72) Inventor: Seitz, Reinhold, Johannes, 91161 Hilpoltstein (DE)
(74) Representative: Wetzel, Emmanuelle

(56) References cited:
- US-A1- 2003 062 326
- US-A1- 2003 223 193
- "Technical Description Alcatel Optimex 1641 SX" September 2001 (2001-09), ALCATEL , XP002535023 * page 71 - page 73; figure 41 *

## Description

The invention relates to the design of racks, e.g. for mounting electrical and/or electronic equipment. In particular, the invention relates to a modular design of a family of racks for telecommunications equipment which allow for a high degree of flexibility.

In the past, 600mm and 300mm deep ETSI rack designs, i.e. racks with a depth of 600mm and 300mm, specified in the ETSI 300119 standard suite have typically been treated separately. By consequence, these rack designs exhibit a certain degree of incompatibility to one another. In particular, these rack designs do not provide a common mounting plane for sub-racks. This means that sub-racks for a 300mm ETSI rack may not easily and economically mounted into a 600mm ETSI rack, due to the fact that the rack up-rights providing the mounting planes or mounting flanges are not positioned in a compatible manner.

Furthermore, current ETSI rack designs often provide too little cabling space and therefore do not meet the requirements for increased connectivity of today's electronic and electrical equipment, notably telecommunication equipment. Furthermore, the access to the cable duct of the current ETSI racks is often obstructed by the rack up-rights, thereby making the cabling of the equipment difficult.

Overall, it may be stated that for current ETSI rack designs, the front/rear positions for sub-rack installations are incompatible for 600mm and 300mm deep racks and both rack designs obstruct the access to the cable duct from the sub-rack front side due to the position of the mounting brackets.

The framework for designing ETSI racks is outlined in the ETSI 300119 standard suite, of which the versions valid on the day of submission of the present patent application are i.e. ETSI EN 300 119-1 V2.1.1 (2004-09), ETSI EN 300 119-1 V2.1.1 (2004-09), ETSI EN 300 119-1 V2.1.1 (2004-09), ETSI EN 300 119-1 V2.1.1 (2004-09), ETSI EN 300 119-1 V2.1.1 (2004-09).

ETSI EN 300 119-1 specifies the terminology used in the context of rack design. In particular, ETSI distinguishes between two types of housings for electrical and/or electronic equipment:
- a cabinet: a free-standing and self-supporting enclosure for housing electrical and/or electronic equipment. It is usually fitted with doors and/or side panels which may or may not be removable; and
- a rack: a free-standing or fixed structure for housing electrical and/or electronic equipment.

EN 300 119-2 specifies the engineering requirements for racks and/or cabinets and EN 300 119-3 specifies the engineering requirements for so-called miscellaneous racks/cabinets, which should be designed to incorporate sub-racks of several types of equipment and/or suppliers. EN 300 119-4 covers engineering requirements for sub-racks in miscellaneous racks. EN 300 119-5 covers the preferred thermal management solutions for sub-racks, racks and/or cabinets and miscellaneous racks and/or cabinets installed indoors in restricted access locations, for the removal of heat dissipated by one or more sub-racks in an ETSI rack.

The document "Technical Description Alcatel Optimex 1641 SX", Sept. 2001 describes ETSI racks for optical transmission equipment. US2003/0062326 describes an adjustable four-column rack design.

In the following, reference will be made to racks. It should be noted that the invention equally applies to cabinets and also to the so-called miscellaneous racks and/or cabinets.

Even though the following description is focusing on racks designed according to the ETSI standard, it should be noted that the present invention may be applied to arbitrary racks designs. In particular, it may be applied to Telcordia / ANSI rack designs used in the United States of America.

The aim of the present invention is to provide racks and sets of racks which exhibit a high degree of compatibility to one another. Such high degree of compatibility will make it possible to mount sub-racks of one type of rack into another type of rack, e.g. mount a sub-rack of a 300mm ETSI rack into a 600mm ETSI rack. This will increase overall modularity and decrease the number of system variants, notably the number of different sub-rack types. Overall, this will lead to a reduction of cost. Furthermore, the invention aims at increasing the amount of available cabling space. In addition, the access to this cabling space should be simplified. The invention also aims at providing a higher flexibility for cabling, in particular a higher flexibility for inter rack cabling. Finally, it should be noted that the invention also considers the aspects of seismic proof design and provides features with regards to this aspect.

An advantage of the rack design according to the present invention is improved access to cabling room in the rack, which is difficult in current ETSI rack designs with front side mounting bracket. Furthermore, the ETSI 300119-2 300mm and 600mm deep racks have no common mounting brackets which requires sub-rack adaptations and variations. This leads to increased system costs. Yet another advantage of the invention is that the rack design with its common features allows for an earthquake proof design without additional mechanical deviations or add-ons.

According to an aspect of the invention, a second rack from a set or a family of racks for mounting sub-racks for optical, electronic and/or electrical equipment is provided. In particular, such equipment may comprise telecommunication equipment, such as access equipment, e.g. DSL (Digital Subscriber Line), PON (Passive Optical Network), etc., transmission equipment, e.g. optical transmission equipment, WDM, etc., switching equipment, e.g. routers, Ethernet switches, etc., wireless network equipment, e.g. base station controllers, etc., and associated power supplies. As a matter of fact, such equipment may comprise all forms of telecommunications equipment and may cover the same scope of equipment as the ETSI 300119 specification, notably ETSI 300119-1.

The set of racks comprises a first rack and the second rack. By way of example, the first and second rack may be two rack types, e.g. the second rack may be a half depth rack and the first rack may be a full depth rack. The first rack comprises a first rack bottom, a first rack top, a first left sided rack up-right and a first right sided rack up-right. Such racks will also be referred to as basic racks, as they comprise the basic elements of a rack without any optional elements, such as front covers, rear covers, side covers and other components. The first left and right sided rack up-rights each comprise a front and rear sub-rack mounting flange. A sub-rack may be mounted at the front and/or rear sub-rack mounting flange. Of course, more than one sub-rack may be mounted at the front and/or rear mounting flange. In order to be adapted for mounting sub-racks, such sub-rack mounting flanges typically comprise hole patterns which are made up of so-called fastening points. In general, sub-racks may be mounted on the front mounting flange as well as on the rear mounting flange at the same time.

The second rack comprises a second rack bottom, a second rack top, a second left sided rack up-right and a second right sided rack up-right, i.e. the second rack also comprises a basic rack structure. Furthermore, the second left and right sided rack up-rights each comprise a front sub-rack mounting flange for mounting a sub-rack. It should be noted that the rack up-rights of the second rack may only comprise front mounting flanges and do not necessary have rear mounting flanges.

The second rack bottom, the second rack top, the second left sided rack up-right and the second right sided rack up-right are firmly attached to one another, such that they form a supporting structure for the second rack. Such firm attachment may e.g. be achieved by welding or screwing the components. The up-rights are fixed within a pre-defined position and are not movable, notably they are not movable along a horizontal direction. The fixation or attachment is preferably such that the firmly attached second rack bottom, the second rack top, the second left sided rack up-right and the second right sided rack up-right can stably support the weight of the equipped sub-racks and of optional rack components, such as rear and/or side covers, doors, etc.. In other words, an optional housing or cabinet has no supporting function and may be detached or removed without impacting the supporting function of the second rack comprising the second rack bottom, the second rack top, the second left sided rack up-right and the second right sided rack up-right.

The up-rights of the first and the second rack are positioned such that the front sub-rack mounting flanges of two second racks mounted back-to-back coincide with the front and rear sub-rack mounting flanges of the first rack. This may be achieved e.g. by respectively adjusting the width and/or the position of the up-rights of the first and the second rack. It should be noted that the two second racks may be directly mounted back-to-back, i.e. their rear may be in direct contact. In such cases no other components are positioned between the two second racks. In other embodiments, the two second racks may be indirectly mounted back-to-back. Such indirect back-to-back positioning may be achieved by using depth extension structures.

According to the invention a set of racks according to claim 1 is provided.

According to another aspect of the invention, the first rack bottom, the first rack top, the first left sided rack up-right and the first right sided rack up-right are firmly attached to one another, such that they form a supporting structure for the first rack. In other words, also the first rack may be a fixed supporting structure as outlined in the context of the second rack.

According to a further aspect of the invention, the first and the second rack bottom and the first and the second rack top have a front and a rear. The first left and right sided rack up-rights are positioned in the center between the front and the rear of the first rack bottom and the first rack top. The second left and right sided rack up-rights are positioned at the rear of the second rack bottom and the second rack top. It is to be noted that in such cases, the up-rights are placed far away from the front and the rear (for the first rack) and the front (for the second rack) of the rack. This way, empty space is made available at the left and right sides of the sub-racks, which allows cables to be placed along these sides without being disturbed by the ears, i.e. the vertical mounting brackets, of the sub-racks. These ears are now placed far away from the front/rear side or the front side of the rack, respectively. Furthermore, it should be noted that the cables remain accessible from the front/rear side, in case of the first rack, and from the front, in case of the second rack.

It is assumed that two second racks are placed back-to-back, one referred to as the second rack A and the other referred to as the second rack B. In such a case the left sided rack up-right of rack A would be adjacent to the right sided rack up-right of rack B. Furthermore, the right sided rack up-right of rack A would be adjacent to the left sided rack up-right of rack B. The front mounting flange of the right sided up-right of rack B would coincide with the rear mounting flange of the left sided up-right of the first rack. The front mounting flange of the left sided up-right of rack A would coincide with the front mounting flange of the left sided up-right of the first rack. The front mounting flange of the right sided up-right of rack A would coincide with the front mounting flange of the right sided up-right of the first rack. And the front mounting flange of the left sided up-right of rack B would coincide with the rear mounting flange of the right sided up-right of the first rack.

According to another aspect, the rack up-rights are U shaped. This may be the case for both or either one of the first and the second rack. As a matter of fact, notably the second rack may only have a partial U shape, e.g. an L shape. This is due to the fact that it only comprises a front sub-rack mounting flange. However, for the purpose of an earthquake proof design, U shaped up-rights may be more appropriate due to their superior stability. The sub-rack mounting flanges correspond to the legs of the U and/or L shaped rack up-rights. Furthermore, it may be beneficial that the aperture of the U and/or L shaped rack up-rights is facing the interior of the first and/or the second rack. This would result in additional available and accessible space which may be used e.g. for cabling purposes and/or air flow.

According to a further aspect of the invention, for the first and the second rack, the left and right rack up-rights are of equal width, respectively. The width of the rack up-rights of the first rack may be twice the width of the rack up-rights of the second rack. It should be noted that manufacturing tolerances may result in this relation to only apply approximately. Furthermore, the width of the rack up-rights of the first rack may be selected such that the first and the second rack are seismic proof, i.e. meet the mechanical stability requirements to withstand earthquakes. This means that when designing the first rack also the requirement with regards to seismic proof of the second rack are taken into consideration.

In particular, it may be desirable that the first and second rack fulfill the requirements of ETSI 300119 Part 5 and/or Telcordia GR63-Core Zone 4 with regards to seismic proof design. One consideration in this regard may be the width of the rack up-rights. By way of example, the width of the first left and right sided rack up-rights may be at least 7 inches, which is approx. 177.8mm, and the width of the second left and right sided rack up-rights may be approx. 3.5 inches or more, i.e. approx. 88.9mm or more.

It should be noted that also other components may contribute to the seismic proof design of the racks. By way of example, the first and/or second rack may further comprise a first and/or second backplane positioned at the rear of the first and/or second rack, respectively. Such backplanes are typically rather stiff and may therefore support the rack stability in case of seismic activity. Furthermore, backplanes are in general relatively heavy compared to other components of an equipped rack. In addition, heavy components of electrical and electronic equipment placed within a rack are often positioned in the vicinity of the backplane. Therefore, the barycenter or the center of gravity of equipped racks is typically in the vicinity of the backplane and it may be beneficial to position the rack up-rights at or in the vicinity of such barycenter or center of gravity.

According to another aspect of the invention, the first and second rack fulfill the requirements of ETSI 300119 Part 2. In particular, the first rack may have a depth of 600 mm and the second rack may have a depth of 300 mm. Furthermore, it should be noted that the racks may comprise additional components, such as side and/or front and/or rear covers which are fixed to the racks in a detachable manner. In other words, such components, e.g. housing components, do not contribute to the supporting structure of the basic rack. As a consequence of the self-supporting feature of the basic rack, the first and/or second rack may further comprise rack side extensions on either side, thereby creating an additional lateral space for cabling and/or thermal management. Such rack side extenders would not be possible, if the side covers were part of the supporting rack structure.

It should be noted that the above mentioned aspects of the invention may be combined with one another or extracted from one another in an arbitrary manner. The objects and features of the invention will become apparent from the following description of preferred embodiments. The present invention is described in the following by referring to exemplary embodiments illustrated schematically in the accompanying figures, wherein
Fig. 1 shows the different rack widths defined by the ETSI standard;
Fig. 2 shows possible rack arrangements described by the ETSI standard in a top view;
Figs. 3 and 4 show an embodiment of a rack in a perspective view;
Fig. 5 illustrates a schematic top view of the rack of Figs 3 and 4;
Figs. 6 and 7 illustrate possible positions of the rack up-rights within a rack;
Fig. 8 shows an embodiment of a compatible set of racks according to the invention;
Fig. 9 illustrates a rack design which is compatible to the rack shown in Figs. 3 and 4;
Fig. 10 illustrates the rack of Fig. 9 with an optional door;
Fig. 11 shows an embodiment for a rack side extension;
Figs. 12 and 13 show schematic top views of racks comprising rack side extensions;
Figs. 14 and 15 illustrate an embodiment of the invention using depth extension structures; and
Fig. 16 illustrates a rack design according to the EIA-310-E specification.

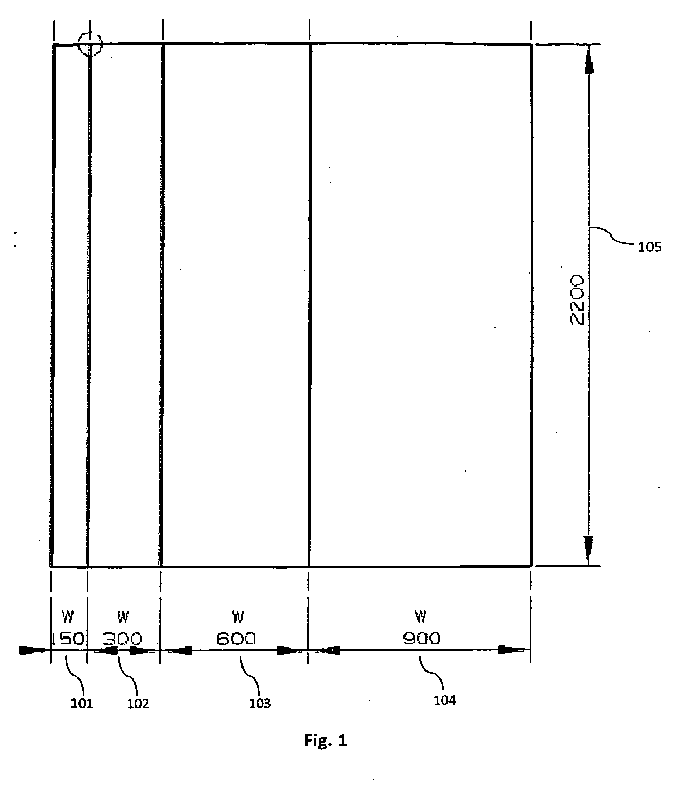

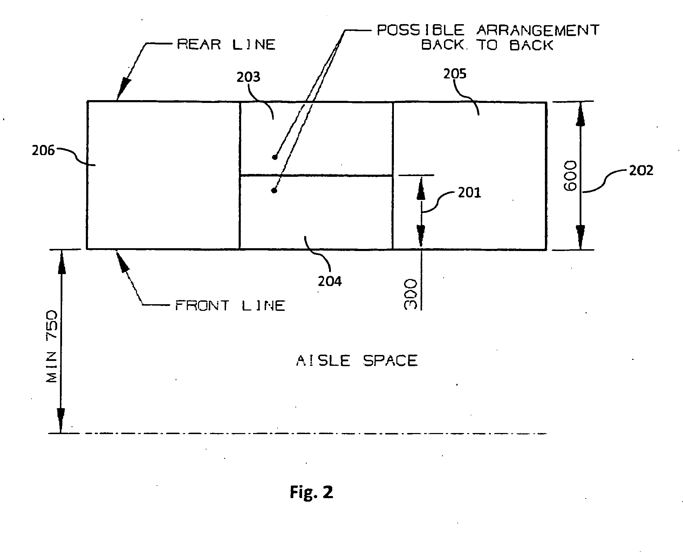

Fig. 1 shows different rack widths defined by the ETSI 300119 standard. ETSI allows a 150mm rack width 101, a 300mm rack width 102, a 600mm rack width 103 and a 900mm rack width 104. For all these racks a standard height 105 of 2200mm is defined. Furthermore, ETSI defines different rack depths of 300mm 201 and 600mm 202, as shown in Fig. 2. It is therefore possible to place two racks 203, 204 with 300mm depth back-to-back. The two racks 203, 204 then have the same depth as the neighboring racks 205 and 206 with a depth of 600mm.

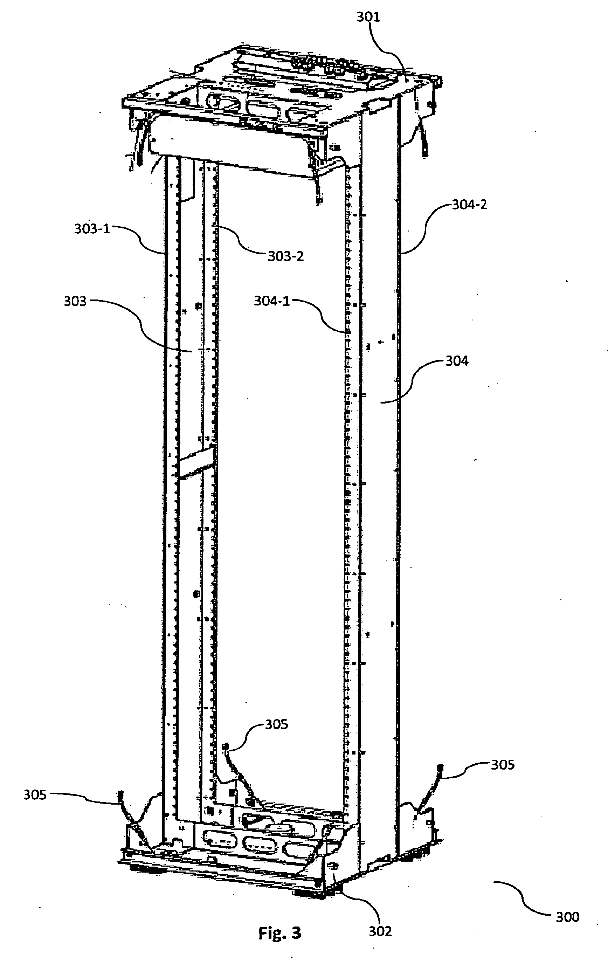

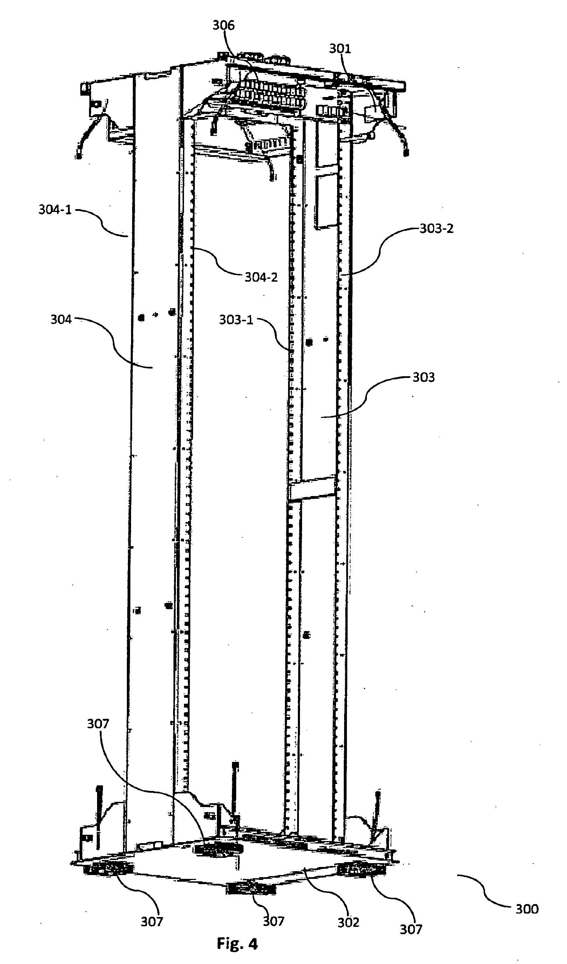

Figs. 3 and 4 illustrate the components of a rack 300, which may also be referred to as the components of a basic rack. Such rack or basic rack 300 comprises a rack top 301, 401, a rack bottom 302, as well as a left sided rack up-right 303 and a right sided rack up-right 304. The left and right sided rack up-rights 303, 304 are typically made up from U-shaped steel having optional stiffening joints. In the illustrated embodiment, the U-shaped rack up-rights are positioned such that the apertures of the rack up-rights face each other, i.e. the apertures of the U face inwards. This has the benefit that the space within the U may be used for cabling electronic and/or electrical components within the rack.

The U shaped rack up-rights each exhibit two mounting flanges 303-1, 303-2 (not shown in Fig. 3) and 304-1, 304-2 (not shown in Fig. 4), respectively. Each mounting flange has a hole pattern made up of so-called fastening points. The ETSI 300119-3 specification specifies dimensions for the positioning of such fastening points, notably a so-called mounting pitch corresponding to the distance between two fasting points.

The left and right sided rack up-rights 303, 304 are affixed to the rack bottom 302 and the rack top 301. This fixation is typically done by welding or screwing the rack up-rights 303, 304 to the rack bottom 302 and rack top 301, such that all rack components are firmly attached. The objective of fixing the rack components to one another is to achieve a self-supporting structure to which sub-racks, as well as optional rear and/or side panels or covers, as well as front doors may be added. Due to the fact that the supporting structure is achieved by the affixed rack bottom 302, rack top 301 and the left and right rack up-rights 303, 304, such panels, covers or doors are not required for the stability of the rack. As a matter of fact, these optional components typically do not contribute to the supporting structure. It is therefore possible to design open rack structures. In particular, it is possible to line up a plurality of such basic racks side by side and to dispense with intermediate side panels. This way, inter-rack cabling may be easily achieved, as cables may be laid directly between the different racks.

It should be noted that Figs. 3 and 4 also illustrate rack components which are add-ons to the basic rack design, i.e. the rack design comprising only a rack bottom 302, a rack top 301 and a left and right rack up-right 303, 304. By way of example, Fig. 3 shows grounding cables 305 and Fig. 4 shows a power distribution panel 306 and adjustable feet 307.

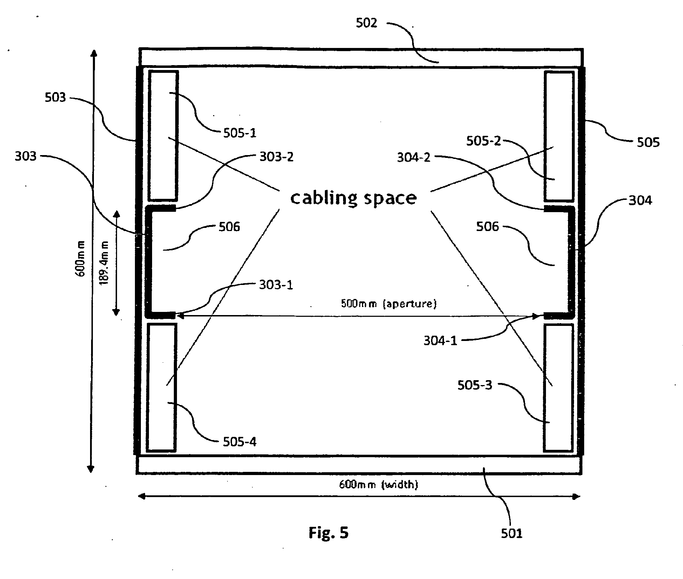

Fig. 5 illustrates a top view of the rack 300 shown in Figs. 3 and 4. Notably, the left rack up-right 303 with its two mounting flanges 303-1 and 303-2 and the right rack up-right 304 with its two mounting flanges 304-1 and 304-2 are shown. As shown in Fig. 5, the two rack up-rights have a width of 189.4mm. Fig. 5 also illustrates that the rack 300 is an ETSI rack with a width of 600mm and a depth of 600mm. Furthermore, it is shown that in accordance to the ETSI 300119-3 specification, the aperture between the mounting flanges is 500mm.

In addition to the rack of Figs. 3 and 4, the rack shown in Fig. 5 has two side covers 503 and 504, as well as a front door 501 and a rear door 502. It can be appreciated that due to the fact that the left and right rack up-rights 303 and 304 are centered between the rear and the front of the rack, cabling space 505-1, 505-2, 505-3 and 505-4 is available between the rack up-rights 303, 304 and the rear/front doors 502, 501, respectively. This cabling space 505-1, 505-2, 505-3 and 505-4 is also easily accessible through the front and rear doors 501, 502. Furthermore, additional cabling space 506 is available within the opening formed by the U shaped rack up-rights 303, 304. This space would not be available, if the U shaped rack up-rights 303, 304 were positioned such that the aperture of the U faced outwards.

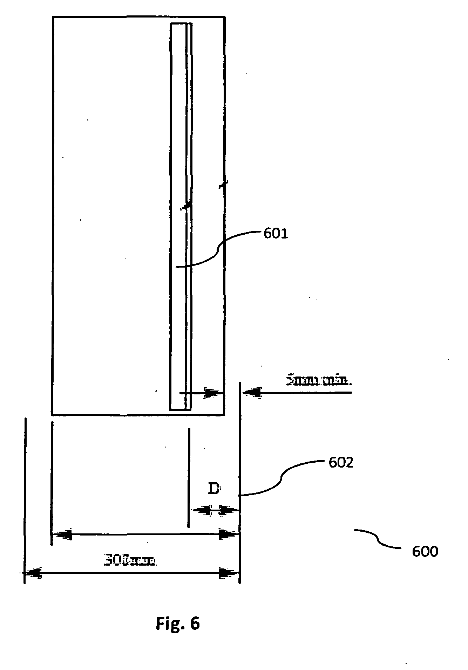

Fig. 6 shows a side view of a rack 600. In the present case a 300mm deep ETSI rack is shown. Furthermore, a rack up-right 601 is shown. According to the ETSI 300119-3 specification, this rack up-right 601 may be positioned at a distance D from the front 602 of the rack 600, whereas a minimum distance of 5mm needs to be observed in order to allow for rack construction, manufacturing tolerances and for clearance for installing sub-racks.

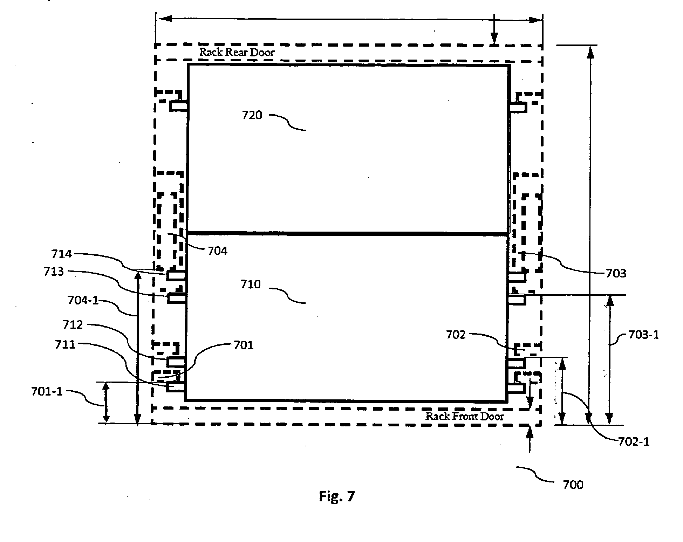

Fig. 7 illustrates possible implementations of distances D in an ETSI rack 700 with a depth of 600mm. The Figure shows two sub-racks 710 and 720 which are mounted back-to-back within the ETSI rack 700. According to the ETSI specification, such sub-racks 710, 720 have a depth of 285mm. Depending on the distance D of the rack up-right from the front of the rack 700, the sub-rack 710 requires mounting flanges 711, 712, 713 and 714 at different positions. By way of example, if the rack 700 has a rack up-right 701 positioned at a distance D 701-1, then the sub-rack 710 requires the mounting flange 711 for an appropriate fixation within the rack 700. If the rack 700 has a rack up-right 702 positioned at a distance D 702-1, then the sub-rack 710 requires the mounting flange 712. If the rack 700 has a rack up-right 703 positioned at a distance D 703-1, then the sub-rack 710 requires the mounting flange 713. Finally, if the rack 700 has a rack up-right 704 positioned at a distance D 704-1, then the sub-rack 710 requires the mounting flange 714. By way of example, the distance D 701-1 may be 41.69mm, the distance D 702-1 may be 50mm, the distance D 703-1 may be 205.3mm and the distance D 704-1 may be 223.5mm.

From this example, it may be appreciated that the large number of possible distances D entails a large number of required sub-rack types. Furthermore, it is typically not possible to easily transfer a sub-rack with a 285mm depth from an ETSI rack with 600mm depth to an ETSI rack with 300mm depth. The reason for this is primarily the incompatibility of the two ETSI racks with regards to the distance D of the rack up-rights from the rack front.

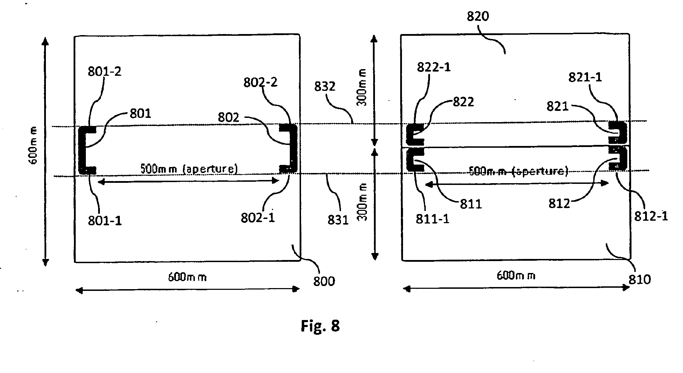

Fig. 8 illustrates an embodiment of a compatible rack design according to the invention. On the left side of Fig. 8 an ETSI rack 800 with a depth of 600mm is shown. On the right side of Fig. 8 two ETSI racks 810 and 820 with depth 300mm and mounted back-to-back are shown. All three racks 800, 810, 820 have a width of 600mm. Fig. 8 also illustrates the rack up-rights of the three racks 800, 810, 820, i.e. the left up-right 801 and the right up-right 802 of rack 800, the left up-right 811 and the right up-right 812 of rack 810 and the left up-right 821 and the right up-right 822 of rack 820. It can be seen that the rack up-rights are positioned such that the combination of the rack up-rights 811 and 822 and the combination of the rack up-rights 812 and 821 is aligned with the rack up-rights 801 and 802. This is indicated by the front alignment line 831 and the rear alignment line 832.

In other words, the rack up-rights of the racks 810 and 820 are designed such that when the two racks 810 and 820 are positioned back-to-back as shown in Fig.8, then their outward facing mounting flanges 811-1, 812-1 and 821-1, 822-1, i.e. their mounting flanges which face the front of the rack, are aligned with the front facing mounting flanges 801-1, 802-1 and the rear facing mounting flanges 801-2, 802-2 of rack 800, respectively. Yet in other words, it may be stated that when the racks 810 and 820 are mounted back-to-back, then their adjacent up-right pairs 811, 822 and 812,821 form combined up-rights, for which the outward facing mounting flanges, i.e. mounting flanges 811-1, 822-1 and 812-1,821-1, respectively are positioned at the same place as the outward facing mounting flanges 801-1, 801-2 and 802-1, 802-2, respectively, of the rack 800, which has the same depth as the racks 810,820, mounted back-to-back.

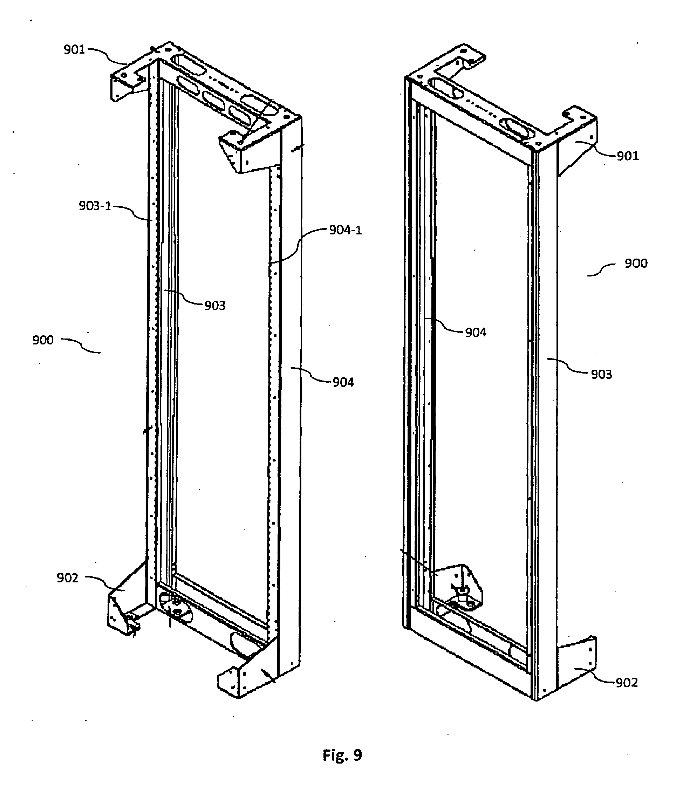

Fig. 9 illustrates a rack 900 which is compatible with the racks shown in Figs. 3 and 4. The rack 900 comprises a rack top 901, a rack bottom 902 as well as a left rack up-right 903 and a right rack up-right 904. On the left side of Fig. 9 a front view of the rack 900 and on the right side a rear view of the rack 900 is shown. It can be appreciated that when two racks 900 are mounted back-to-back then the combined rack resembles rack 300 of Figs. 3 and 4. In particular, it may be stated that in such case, the mounting flanges 903-1 and 904-1 are aligned with the mounting flanges 303-1 and 304-1 as well as the mounting flanges 304-2 and 303-2 of rack 300. Consequently, rack 300 and rack 900 form a set of racks according to the invention.

Furthermore, Fig. 9 shows the bare basic rack structure comprising only the rack top 901, the rack bottom 902 as well as the left rack up-right 903 and the right rack up-right 904. It may be appreciated that these basic components form a support frame, when firmly attached to each other. This support frame forms the supporting element of the rack and may stably carry the sub-racks, the electronic and/or electrical components as well as other optional components, such as covers, panels and doors. The stability of this support frame may be further improved by selecting appropriate materials for the basic components and/or by using stabilizing cross-sections. As shown in Fig. 9 all basic components, i.e. the rack top 901, the rack bottom 902 as well as the left rack up-right 903 and the right rack up-right 904 have a U shaped cross-section, which improves the stability of the support frame.

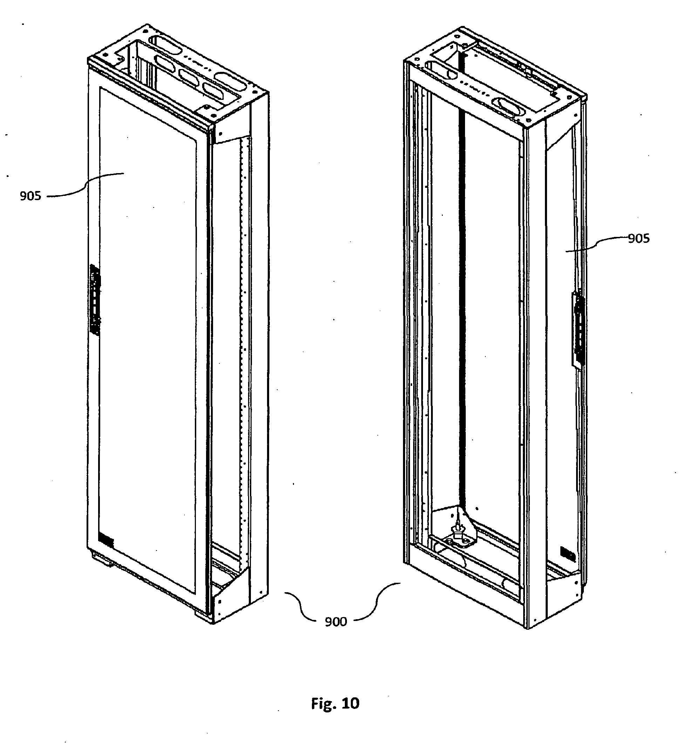

Fig. 10 illustrates rack 900 with an optional door 905 in a front and a rear view. As already stated above, it should be noted that the basic racks according to the invention may only consist of a rack top, a rack bottom as well as a left up-right and a right up-right. These components are affixed with one another such that they from a supporting structure for other optional components, such as rear panels or covers, side panels or covers and doors. The basic rack may also support the sub-racks without additional supporting elements, notably without an additional housing. This self-supporting feature of the basic rack has the benefit that it allows the line-up of open racks. This largely simplifies the inter-rack cabling. By way of example, a plurality of open racks may be lined up. These lined-up racks may have a joint housing without any intermediate side panels between each individual rack.

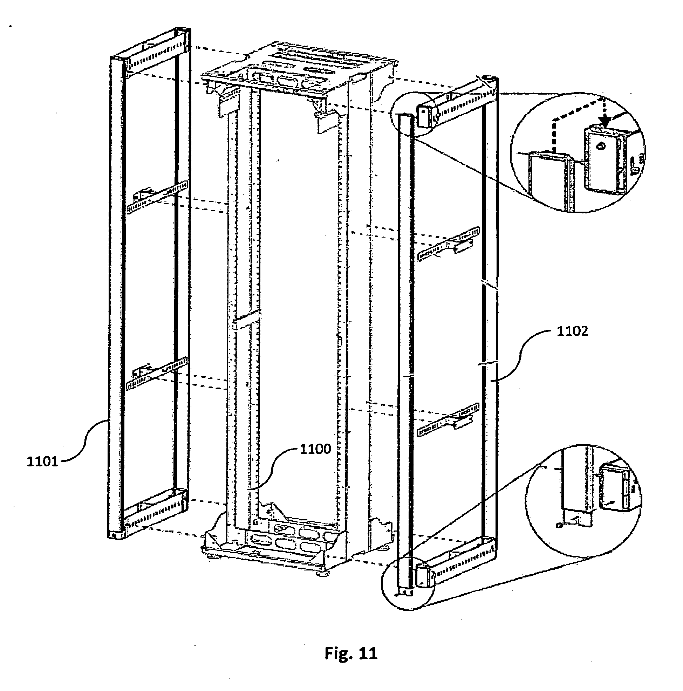

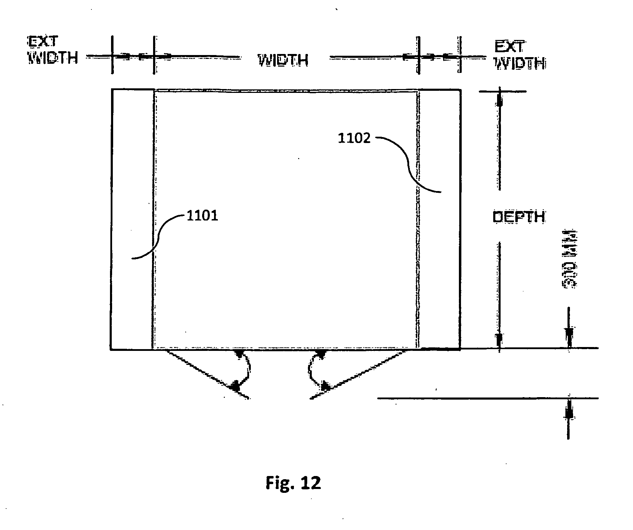

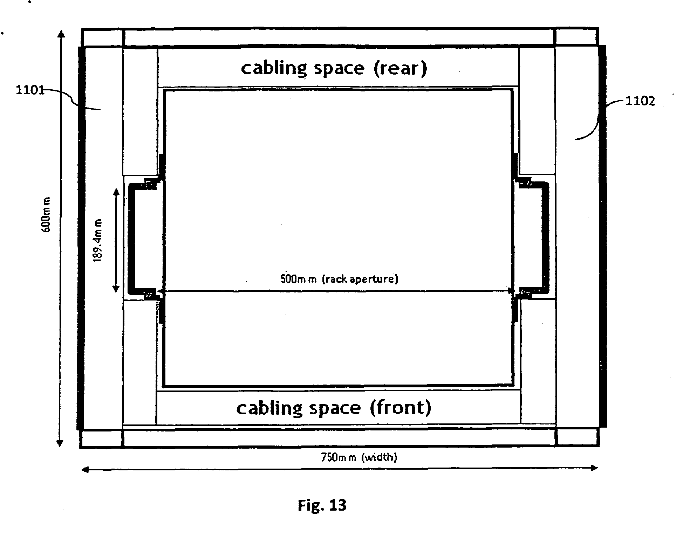

Fig. 11 illustrates the possibility to create additional space alongside a rack 1100 by using so-called side rack extenders 1101 and 1102. Such lateral side rack extenders 1101, 1102 have the benefit of providing additional cabling space. They also allow for additional thermal management options, as the additional space may be used to improve the airflow and convection within the rack. Fig.12 and 13 are top views of racks having additional rack side extenders 1101 and 1102. In Fig. 13 it is shown that for a 600mm wide rack, rack side extenders 1101 and 1102, each having a width of 75mm, may be used, such that the overall width of the rack including rack side extenders 1101, 1102 is 750mm. In a similar manner, rack side extenders may also be used for other rack types, notably for rack types with a depth of 300mm. It may be appreciated that by inserting rack side extenders of a combined width according to the ETSI width requirements shown in Fig. 1, the ETSI standard rack arrangements may be fulfilled.

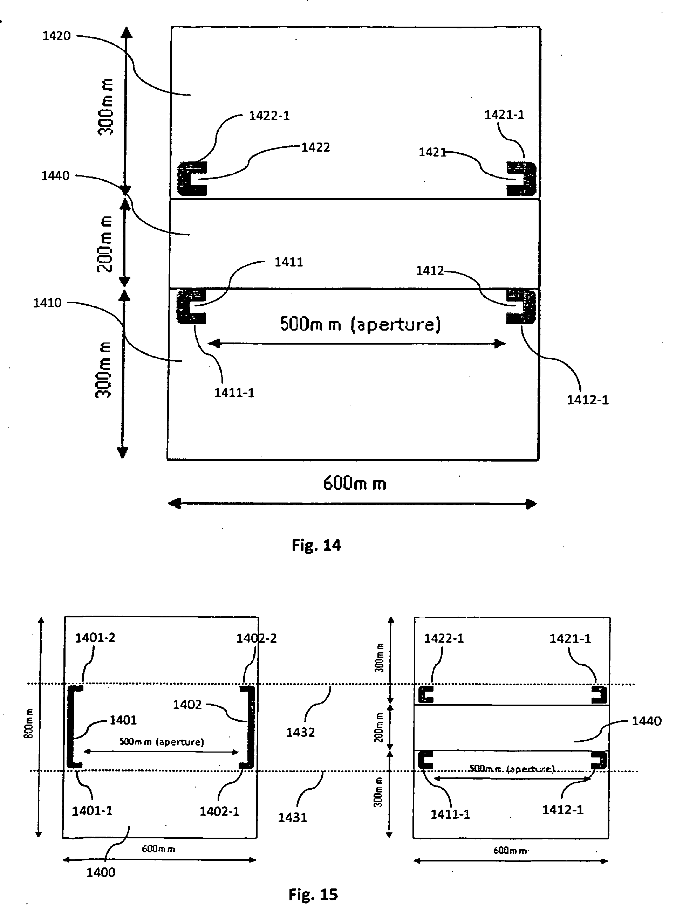

Figs. 14 and 15 illustrate an embodiment of the invention using additional depth extenders or depth extension structures 1440. The Figures show two 300mm racks 1410, 1420 which are mounted back-to-back. The first 300mm rack 1410 comprises a left rack up-right 1411 and a right rack up-right 1412. These rack up-rights exhibit front side sub-rack mounting flanges 1411-1 and 1412-1, respectively. In an analogous manner, the rack 1420 comprises a left sided rack up-right 1421 and a right sided rack up-right 1422, each comprising front mounting flanges 1421-1 and 1422-1, respectively. Instead of being directly mounted back-to-back, a depth extension structure 1440 has been placed between the two racks 1410, 1420. Due to the fact that the racks 1410, 1420 are self-supporting structures, such depth extenders 1440 do not require own supporting structure elements.

Fig. 15 illustrates how such depth extension structures may be used for the alignment of the mounting flanges. The left side of Fig. 15 illustrates an 800mm deep rack 1400, i.e. a rack with an increased depth. Such racks 1400 may e.g. be used to house servers and/or routers. The illustrated rack 1400 comprises two up-rights 1401 and 1402. It should be noted that the up-rights 1401 and 1402 of rack 1400 are only exemplary and may take on other forms. It can be seen that through the use of the depth extension structure 1440, the front mounting flanges of rack 1410 may be aligned with the front mounting flanges 1401-1 and 1402-1 of rack 1400. In the same manner, the front mounting flanges of rack 1420 may be aligned with rear mounting flanges of rack 1400, i.e. mounting flanges 1401-2 and 1402-2. These alignments are illustrated by the lines 1431 and 1432, respectively.

Furthermore, as has already been noted, the present invention is not limited to ETSI standardized rack designs, but may equally be applied to other rack types, e.g. the North-American racks specified in EIA/ECA-310-E.

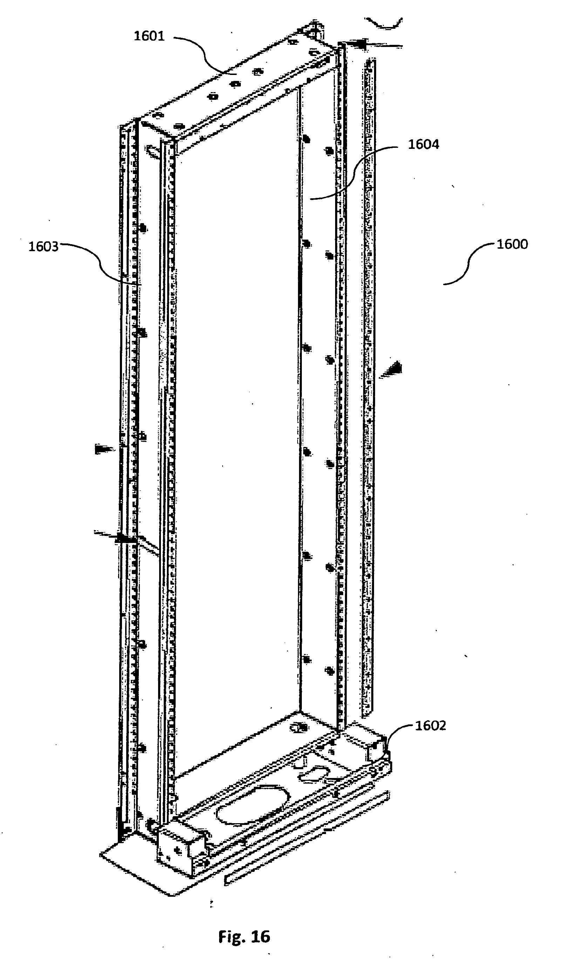

Fig. 16 shows a rack 1600 according to the above mentioned EIA-310-E Standard. In particular, the illustrated rack 1600 is an SNBF (Seismic Network Bay Frame) type rack. This rack 1600 comprises a rack top 1601, a rack bottom 1602 as well as a left rack up-right 1303 and a right rack up-right 1304. It should be noted that the illustrated prior art rack cannot be mounted back-to-back and are designed to provide access from the rear. Furthermore, the EIA-310-E Standard defines width variants in multiple of inches, .e.g. 19 inch and 23 inch width racks. It can also be seen from Fig. 16, that the U shaped up-rights 1303, 1304 are turned outward, i.e. the U shaped cross-sections are oriented towards the exterior of the rack 1600. As outlined above, this is disadvantageous as the space within the U shaped profile may not be used for cabling and/or air flow purposes. Nevertheless, the aspects of the invention may also be applied to the rack types specified in EIA-310-E.

In the present document a modular rack type and a set of racks has been presented which allow for a high degree of compatibility. Due to this, it is possible to mount the same type of sub-racks in racks having different depth. In particular, it is possible to mount the same 285mm sub-racks back-to-back into a rack of 600mm depth. It is also possible to mount such 285mm sub-racks into racks of 300mm width. If two such 300mm deep racks are placed back-to-back, then such arrangement corresponds to a 600mm deep rack comprising 285mm sub-racks mounted back-to-back. In addition to increasing the modularity of rack designs, the invention provides an increase cable duct size and improved cable accessibility.

The outlined embodiments are based on 600mm and 300mm deep rack designs which follow the standardized platform of ETSI 300119-1 and 300119-2. As already indicated above, the invention is not limited to such ETSI designs, but may be equally applicable to other standardized or non standardized designs. In the context of ETSI, the invention allows a common rack design for 300mm and 600mm deep racks with improved cabling room and modular installation options based on installation compatibility and mechanical interfaces for both 300mm and 600mm deep racks. Both rack types rely on a core design which represents the basic structure for a rack, i.e. the rack bottom, rack top and the rack up-rights which provide the mounting holes for the sub-racks to be installed. Any other features, e.g. side panels or doors, do not belong to the basic structure but can be added optionally with various design choices.

The invention provides numerous benefits, such as:
- It follows the ETSI 300119 Part 2 specification and may be directly applicable to other specification, e.g. Telcordia and/or ANSI.
- It provides full installation compatibility for installing rack line-ups with 300mm and 600mm depth.
- It may comprise the step of shifting the sub-rack mounting plane, i.e. the sub-rack mounting flanges, defined in ETSI 300119 part 3 and 4 to the rear of the rack. This allows for more room for improved cable management.
- It suggests dividing a 600mm deep rack footprint into 2 x 300mm rack footprints such that both rack types, i.e. the 600mm and the 300mm rack, provide the same sub-rack fixation plane, i.e. the same position of the sub-rack mounting flanges.
- It suggests the use of 300mm depth racks and 600mm depth racks with back-to-back compatibility. Such compatibility provides the option to mount two 285mm deep sub-racks back-to-back in a 600x600mm footprint rack or alternatively to mount two 285mm deep sub-racks, one each in a 600x300mm footprint rack, whereas the two 600x300mm racks are positioned back-to-back.
- It offers the advantage that 600mmm sub-racks may be fixed at the middle of the depth of the sub-rack, i.e. at about 300mm from the front side, which provides a better weight distribution for the sub-rack, i.e. a lower level effect.
- It allows for detachable side/rear covers. This issue is achieved by the fact that the basic rack structure, i.e. the rack bottom, the rack top and the rack up-rights, provide the stability of the rack. Consequently, no housing elements, e.g. side/rear covers, are required as a supporting structure.
- It suggests using optional rack side extensions in order to create enhanced cabling space and additional thermal management options. These optional rack side extenders may be modular for all rack types, i.e. notably for the racks with 300mm and 600mm depth. It should be noted that these rack side extenders are mounted onto the basic rack structure and therefore do not require an own supporting structure.
- As already outlined, the basic rack structure may only comprise a rack bottom, a rack top and rack up-rights used for mounting sub-rack. As this basic rack structure provides the rack stability, the rack side structure may be kept open for adding optionally extra side extensions to increase cabling space in rack line-ups. As a matter of fact, for an optional housing only the first and last rack in the line-up would require side plates. Furthermore, such open designs allow for simple and direct cabling between adjacent racks.
- It allows the use of depth extension structures. Such depth extension structures may be mounted between two 300mm deep racks that are mounted back-to-back. Through the use of these depth extension structures, the mounting flanges of the 300mm deep racks may be aligned with the mounting flanges of racks having a depth of more than 600mm, notably server racks.
- It foresees a rack up-right and/or sub-rack mounting plane design, such that not only a 600mm deep rack is an earthquake proof design but also a 300mm deep rack. The up-rights of the 600mm rack may be designed such that the compatible up-rights of the 300mm rack are also earthquake proof. By way of example, the up-right of the 600mm rack may have a 7 inch (approx. 178mm) width and the up-right of the compatible 300mm rack may have a 3.5 inch (approx. 89mm) width. It should be noted that these numbers may vary as a result of manufacturing tolerances. Consequently, Seismic Proof Designs, notably Telcordia GR63-Core Zone 4 and ETSI 300 119-5, may be optionally provided, notably for the 300mm and 600mm deep racks described in the embodiments. Furthermore, the mounting principles of SNBF (Seismic Network Bay Frame) which are used in USA telecommunication offices may be applied.

## Claims

1. A set of racks for mounting sub-racks for optical, electronic and/or electrical equipment, the set comprising a first rack (800) and two second racks (810, 820), wherein
- the first rack (800) comprises a first rack bottom (302), a first rack top (301), a first left side rack up-right (801) and a first right side rack up-right (802);
- the first left side rack up-right (801) and the first right side rack up-right (802) each comprise a front sub-rack mounting flange (801-1, 802-1) and a rear sub-rack mounting flange (801-2, 802-2), each for mounting a sub-rack;
- each second rack (810, 820) comprises a second rack bottom (902), a second rack top (901), a second left side rack up-right (811, 821) and a second right side rack up-right (812, 822);
- the second left side rack up-right (811, 821) and the second right side rack up-right (812, 822) of each second rack (810, 820) comprise a front sub-rack mounting flange (811-1, 821-1, 812-1, 822-1) for mounting a sub-rack;
- the second rack bottom (902), the second rack top (901), the second left side rack up-right (811, 821) and the second right side rack up-right (812, 822) of each second rack (810, 820) are firmly attached to one another, such that they form a supporting structure for the same second rack (810, 820); **characterized in that**
- the front sub-rack mounting flanges (811-1, 812-1,) of one of the second racks (810,) are aligned with the front sub-rack mounting flanges (801-1, 802-1) of the first rack (800);
- the front sub-rack mounting flanges (821-1, 822-1) of the other of the second racks (820) are aligned with the rear sub-rack mounting flanges (801-2, 802-2) of the first rack (800); and
- the two second racks (810, 820) are mounted back-to-back to have a combined depth which is the same as a depth of the first rack (800).

2. The set of racks of claim 1, wherein
- the first rack bottom (302), the first rack top (301), the first left side rack up-right (801) and the first right side rack up-right (802) are firmly attached to one another, such that they form a supporting structure for the first rack (800).

3. The set of racks of claim 1, wherein
- the first rack bottom (302) and the second rack bottom (902) and the first rack top (301) and the second rack top (901) have a front and a rear;
- the first left side rack up-right (801) and the first right side rack up-right (802) are positioned in the center between the front and the rear of the first rack bottom (302) and the first rack top (301); and
- the second left side rack up-right (811) and the second right side rack up-right (812) are positioned at the rear of the second rack bottom (902) and the second rack top (901).

4. The set of racks of claim 1, wherein
- the first left side rack up-right (801), the first right side rack up-right (802), the second left side rack up-rights (811, 821) and the second right side rack up-rights (812, 822) are U shaped; and
- the sub-rack mounting flanges (801-1, 801-2, 802-1, 802-2, 811-1, 812-1, 821-1, 822-1) correspond to the legs of the U shaped rack up-rights (801, 802, 811, 812, 821, 822).

5. The set of racks of claim 4, wherein
- the aperture of the U shaped rack up-rights (801, 802, 811, 812, 821, 822) is facing the interior of the first rack (800) and/or the two second racks (810, 820).

6. The set of racks of claim 1, wherein
- for the first rack (800) and the two second (810, 820) racks, the left and the right side rack up-rights (801, 802, 811, 812, 821, 822) are of equal width, respectively; and
- the width of the rack up-rights (801, 802) of the first rack (800) is twice the width of the rack up-rights (811, 812, 821, 822) of the second rack (810, 820).

7. The set of racks of claim 1, wherein
- the first rack (800) and the two second racks (810, 820) fulfill the requirements of ETSI 300119 Part 2.

8. The set of racks of claim 1, wherein
- a depth extension structure (1440) is positioned between the two second racks (810, 820) that are mounted back-to-back.

9. The set of racks of claim 1, wherein
- the first rack (800) and the two second racks (810, 820) further comprise side and/or front and/or rear covers which are fixed in a detachable manner.

10. The set of racks of claim 1, wherein
- the first rack (800) and the two second racks (810, 820) fulfill the requirements of ETSI 300119 Part 5 and/or Telcordia GR63-Core Zone 4 with regards to seismic proof design.

11. The set of racks of claim 10, wherein
- the width of the first left side rack up-right (801) and the first right side rack up-right (802) is at least 177,80 mm (7 inches); and
- the width of the second left side rack up-rights (811, 821) and the second right side rack up-rights (812, 822) is at least 88,90 mm (3.5 inches).

12. The set of racks of claim 10, wherein
- each second rack (810, 820) further comprises a second backplane positioned at the rear of each second rack (810,820); and
- the second left side rack up-rights (811, 821) and the second right side rack up-rights (812, 822) are positioned at the barycenter of the second rack (810, 820).

13. The set of racks of claim 1, wherein
- the first rack (800) and/or the two second racks (810, 820) further comprise a rack side extension (1101, 1102), thereby creating an additional lateral space for cabling and/or thermal management.

## Patentansprüche

1. Satz von Baugruppenträgern zum Befestigen von Teil-Baugruppenträgern für optische, elektronische und/oder elektrische Vorrichtungen, wobei der Satz einen ersten Baugruppenträger (800) und zwei zweite Baugruppenträger (810, 820) umfasst, wobei
- der erste Baugruppenträger (800) einen ersten Baugruppenträgerboden (302), einen ersten Baugruppenträgeroberteil (301), einen ersten linken Baugruppenträgerständer (801) und einen ersten rechten Baugruppenträgerständer (802) umfasst;
- der erste linke Baugruppenträgerständer (801) und der erste rechte Baugruppenträgerständer (802) jeweils einen vorderen Flansch zur Befestigung eines Teil-Baugruppenträgers (801-1, 802-1) und einen hinteren Flansch zur Befestigung eines Teil-Baugruppenträgers (801-2, 802-2), jeweils zum Befestigen eines Teil-Baugruppenträgers, umfassen,
- jeder zweite Baugruppenträger (810, 820) einen zweiten Baugruppenträgerboden (902), einen zweite Baugruppenträgeroberteil (901), einen zweiten linken Baugruppenträgerständer (811, 821) und einen zweiten rechten Baugruppenträgerständer (812, 822) umfasst,
- der zweite linke Baugruppenträgerständer (811, 821) und der zweite rechte Baugruppenträgerständer (812, 822) eines jeden zweiten Baugruppenträgers (810, 820) einen vorderen Flansch zur Befestigung eines Teil-Baugruppenträgers (811-1, 821-1, 822-1) zum Befestigen eines Teil-Baugruppenträgers umfassen;
- der zweite Baugruppenträgerboden (902), der zweite Baugruppenträgeroberteil (901), der zweite linke Baugruppenträgerständer (811, 821) und der zweite rechte Baugruppenträgerständer (812, 822) eines jeden zweiten Baugruppenträgers (810, 820) fest miteinander verbunden sind, so dass sie eine Trägerstruktur für denselben zweiten Baugruppenträger (810, 820) bilden, **dadurch gekennzeichnet, dass**
- die vorderen Flansche zur Befestigung des Teil-Baugruppenträgers (811-1, 812-1) eines der zweiten Baugruppenträger (810) mit den vorderen Flanschen zur Befestigung des Teil-Baugruppenträgers (801-1, 802-1) des ersten Baugruppenträgers (800) ausgerichtet sind;
- die vorderen Flansche zur Befestigung des Teil-Baugruppenträgers (821-1, 822-1) des anderen der zweiten Baugruppenträger (820) mit den hinteren Flanschen zur Befestigung des Teil-Baugruppenträgers (801-2, 802-2) des ersten Baugruppenträgers (800) ausgerichtet sind; und
- die beiden zweiten Baugruppenträger (810, 820) Rücken an Rücken montiert sind, um eine kombinierte Tiefe, welche der Tiefe des ersten Baugruppenträgers (800) entspricht, aufzuweisen.

2. Satz von Baugruppenträgern nach Anspruch 1, wobei
- der erste Baugruppenträgerboden (302), der erste Baugruppenträgeroberteil (301), der erste linke Baugruppenträgerständer (801) und der erste rechte Baugruppenträgerständer (802) fest miteinander verbunden sind, so dass sie eine Trägerstruktur für den ersten Baugruppenträger (800) bilden.

3. Satz von Baugruppenträgern nach Anspruch 1, wobei
- der erste Baugruppenträgerboden (302) und der zweite Baugruppenträgerboden (902) und der erste Baugruppenträgeroberteil (301) und der zweite Baugruppenträgeroberteil (901) eine Vorderseite und eine Rückseite aufweisen;
- der erste linke Baugruppenträgerständer (801) und der erste rechte Baugruppenträgerständer (802) in der Mitte zwischen der Vorderseite und der Rückseite des ersten Baugruppenträgerbodens (302) und des ersten Baugruppenträgeroberteils (301) angeordnet sind; und
- der zweite linke Baugruppenträgerständer (811) und der zweite rechte Baugruppenträgerständer (812) an der Rückseite des zweiten Baugruppenträgerbodens (902) und des zweiten Baugruppenträgeroberteils (901) angeordnet sind.

4. Satz von Baugruppenträgern nach Anspruch 1, wobei
- der erste linke Baugruppenträgerständer (801), der erste rechte Baugruppenträgerständer (802), die zweiten linken Baugruppenträgerständer (811, 821) und die zweiten rechten Baugruppenträgerständer (812, 822) eine U-Form aufweisen; und
- die Flansche zur Befestigung des Teil-Baugruppenträgers (801-1, 801-2, 802-1, 802-1, 811-1, 812-1, 821-1, 822-1) den Beinen der U-förmigen Baugruppenträgerständer (801, 802, 811, 812, 821, 822) entsprechen.

5. Satz von Baugruppenträgern nach Anspruch 4, wobei
- die Öffnung der U-förmigen Baugruppenträgerständers (801, 802, 811, 812, 821, 822) dem Inneren des ersten Baugruppenträgers (800) und/oder den beiden zweiten Baugruppenträgern (810, 820) gegenüberliegen.

6. Satz von Baugruppenträgern nach Anspruch 1, wobei
- für den ersten Baugruppenträger (800) und die beiden zweiten Baugruppenträger (810, 820), die linken und die rechten Baugruppenträgerständer (801, 802, 811, 812, 821, 822) jeweils eine selbe Breite aufweisen; und
- die Breite der Baugruppenträgerständer (801, 802) des ersten Baugruppenträgers (800) die doppelte Breite der Baugruppenträgerständer (811, 812, 821, 822) des zweiten Baugruppenträgers (810, 820) beträgt.

7. Satz von Baugruppenträgern nach Anspruch 1, wobei
- der erste Baugruppenträger (800) und die beiden zweiten Baugruppenträger (810, 820) die Anforderungen von ETSI 300119 Teil 2 erfüllen.

8. Satz von Baugruppenträgern nach Anspruch 1, wobei
- eine Tiefenerweiterungsstruktur (1440) zwischen den beiden zweiten Baugruppenträgern (810, 820), welche back-to-back mounted sind, angeordnet ist.

9. Satz von Baugruppenträgern nach Anspruch 1, wobei
- der erste Baugruppenträger (800) und die beiden zweiten Baugruppenträger (810, 820) weiterhin seitliche und/oder vordere und/oder hintere Abdeckungen umfassen, welche in einer abnehmbaren Weise befestigt sind.

10. Satz von Baugruppenträgern nach Anspruch 1, wobei
- der erste Baugruppenträger (800) und die beiden zweiten Baugruppenträger (810, 820) die Anforderungen von ETSI 300119 Teil 5 und/oder Telcordia GR63-Core Zone 4 in Bezug auf das erdbebensichere Design erfüllen.

11. Satz von Baugruppenträgern nach Anspruch 10, wobei
- die Breite des ersten linken Baugruppenträgerständers (801) und des ersten rechten Baugruppenträgerständers (802) mindestens 177,80 mm (7 Inch) beträgt, und
- die Breite der zweiten linken Baugruppenträgerständer (811, 821) und der zweiten rechten Baugruppenträgerständer (812, 822) mindestens 88,90 mm (3,5 Inch) beträgt.

12. Satz von Baugruppenträgern nach Anspruch 10, wobei
- jeder zweite Baugruppenträger (810, 820) weiterhin einen zweiten Rückwandbus umfasst, welche an der Rückseite eines jeden zweiten Baugruppenträgers (810, 820) angeordnet ist; und
- die zweiten linken Ständer des Baugruppenträgers (811, 821) und die zweiten rechten Ständer des Baugruppenträgers (812, 822) am Massenmittelpunkt des zweiten Baugruppenträgers (810, 820) angeordnet sind.

13. Satz von Baugruppenträgern nach Anspruch 1, wobei
- der erste Baugruppenträger (800) und/oder die beiden zweiten Baugruppenträger (810, 820) weiterhin eine Baugruppenträger-Seitenerweiterung (1101, 1102) aufweisen, wodurch ein zusätzlicher seitlicher Raum für die Verkabelung und/oder das Wärmemanagement geschaffen wird.

## Revendications

1. Ensemble d'étagères pour monter des sous-étagères pour un équipement optique, électronique et/ou électrique, l'ensemble comprenant une première étagère (800) et deux deuxièmes étagères (810, 820), dans lequel
- la première étagère (800) comprend une première partie inférieure d'étagère (302), une première partie supérieure d'étagère (301), un premier montant d'étagère côté gauche (801) et un premier montant d'étagère côté droit (802) ;
- le premier montant d'étagère côté gauche (801) et le premier montant d'étagère côté droit (802) comprennent chacun une bride de montage de sous-étagère avant (801-1, 802-1) et une bride de montage de sous-étagère arrière (801-2, 802-2), chacune permettant de monter une sous-étagère ;
- chaque deuxième étagère (810, 820) comprend une deuxième partie inférieure d'étagère (902), une deuxième partie supérieure d'étagère (901), un deuxième montant d'étagère côté gauche (811, 821) et un deuxième montant d'étagère côté droit (812, 822) ;
- le deuxième montant d'étagère côté gauche (811, 821) et le deuxième montant d'étagère côté droit (812, 822) de chaque deuxième étagère (810, 820) comprennent une bride de montage de sous-étagère avant (811-1, 821-1, 812-1, 822-1) pour monter une sous-étagère ;
- la deuxième partie inférieure d'étagère (902), la deuxième partie supérieure d'étagère (901), le deuxième montant d'étagère côté gauche (811, 821) et le deuxième montant d'étagère côté droit (812, 822) de chaque deuxième étagère (810, 820) sont fermement fixés les uns aux autres, de sorte qu'ils forment une structure de support pour la même deuxième étagère (810, 820) ; **caractérisé en ce que**
- les brides de montage de sous-étagère avant (811-1, 812-1) d'une des deuxièmes étagères (810) sont alignées avec les brides de montage de sous-étagère avant (801-1, 802-1) de la première étagère (800) ;
- les brides de montage de sous-étagère avant (821-1, 822-1,) de l'autre parmi les deuxièmes étagères (820) sont alignées avec les brides de montage de sous-étagère arrière (801-2, 802-2) de la première étagère (800) ; et
- les deux deuxièmes étagères (810, 820) sont montées dos à dos pour avoir une profondeur combinée qui est identique à une profondeur de la première étagère (800).

2. Ensemble d'étagères selon la revendication 1, dans lequel
- la première partie inférieure d'étagère (302), la première partie supérieure d'étagère (301), le premier montant d'étagère côté gauche (801) et le premier montant d'étagère côté droit (802) sont fermement fixés les uns aux autres, de sorte qu'ils forment une structure de support pour la première étagère (800).

3. Ensemble d'étagères selon la revendication 1, dans lequel
- la première partie inférieure d'étagère (302) et la deuxième partie inférieure d'étagère (902) et la première partie supérieure d'étagère (301) et la deuxième partie supérieure d'étagère (901) présentent une partie avant et une partie arrière ;
- le premier montant d'étagère côté gauche (801) et le premier montant d'étagère côté droit (802) sont positionnés au centre entre la partie avant et la partie arrière de la première partie inférieure d'étagère (302) et de la première partie supérieure d'étagère (301) ; et
- le deuxième montant d'étagère côté gauche (811) et le deuxième montant d'étagère côté droit (812) sont positionnés à l'arrière de la deuxième partie inférieure d'étagère (902) et de la deuxième partie supérieure d'étagère (901).

4. Ensemble d'étagères selon la revendication 1, dans lequel
- le premier montant d'étagère côté gauche (801), le premier montant d'étagère côté droit (802), les deuxièmes montants d'étagère côté gauche (811, 821) et les deuxièmes montants d'étagère côté droit (812, 822) sont en forme de U ; et
- les brides de montage de sous-étagère (801-1, 801-2, 802-1, 802-2, 811-1, 812-1, 821-1, 822-1) correspondent aux jambes des montants d'étagère en forme de U (801, 802, 811, 812, 821, 822).

5. Ensemble d'étagères selon la revendication 4, dans lequel
- l'ouverture des montants d'étagère en forme de U (801, 802, 811, 812, 821, 822) fait face à l'intérieur de la première étagère (800) et/ou des deux deuxièmes étagères (810, 820).

6. Ensemble d'étagères selon la revendication 1, dans lequel
- pour la première étagère (800) et les deux deuxièmes (810, 820) étagères, les montants d'étagère côtés gauche et droit (801, 802, 811, 812, 821, 822) sont de même largeur, respectivement ; et
- la largeur des montants d'étagère (801, 802) de la première étagère (800) fait le double de la largeur des montants d'étagère (811, 812, 821, 822) de la deuxième étagère (810, 820).

7. Ensemble d'étagères selon la revendication 1, dans lequel
- la première étagère (800) et les deux deuxièmes étagères (810, 820) répondent aux exigences de la norme ETSI 300119 Partie 2.

8. Ensemble d'étagères selon la revendication 1, dans lequel
- une structure d'extension de profondeur (1440) est positionnée entre les deux deuxièmes étagères (810, 820) qui sont montées dos à dos.

9. Ensemble d'étagères selon la revendication 1, dans lequel
- la première étagère (800) et les deux deuxièmes étagères (810, 820) comprennent en outre des couvercles latéraux et/ou avant et/ou arrière qui sont fixés de manière détachable.

10. Ensemble d'étagères selon la revendication 1, dans lequel
- la première étagère (800) et les deux deuxièmes étagères (810, 820) répondent aux exigences de la norme ETSI 300119 Partie 5 et/ou de la norme Telcordia GR63-Core Zone 4 en ce qui concerne la conception antisismique.

11. Ensemble d'étagères selon la revendication 10, dans lequel
- la largeur du premier montant d'étagère côté gauche (801) et du premier montant d'étagère côté droit (802) est au moins de 177,80 mm (7 pouces) ; et
- la largeur des deuxièmes montants d'étagère côté gauche (811, 821) et des deuxièmes montants d'étagère côté droit (812, 822) est au moins de 88,90 mm (3,5 pouces).

12. Ensemble d'étagères selon la revendication 10, dans lequel
- chaque deuxième étagère (810, 820) comprend en outre une deuxième face arrière positionnée à l'arrière de chaque deuxième étagère (810, 820) ; et
- les deuxièmes montants d'étagère côté gauche (811, 821) et les deuxièmes montants d'étagère côté droit (812, 822) sont positionnés au barycentre de la deuxième étagère (810, 820).

13. Ensemble d'étagères selon la revendication 1, dans lequel
- la première étagère (800) et/ou les deux deuxièmes étagères (810, 820) comprennent en outre une extension latérale d'étagère (1101, 1102), créant ainsi un espace latéral supplémentaire pour le câblage et/ou la gestion thermique.
